# EUROPÄISCHE PATENTSCHRIFT

(11) **EP 1 292 648 B1**
(45) Veröffentlichungstag und Bekanntmachung des Hinweises auf die Patenterteilung: **11.04.2007**
(21) Anmeldenummer: 01964955.7
(22) Anmeldetag: 01.06.2001
(51) Int. Cl.: H01L 29/36, H01L 29/778

(54) **HETEROSTRUKTUR MIT RÜCKSEITIGER DONATORDOTIERUNG**
HETEROSTRUCTURE WITH REAR-FACE DONOR DOPING
HETEROSTRUCTURE AVEC DOPAGE PAR DONNEURS SUR LA FACE ARRIERE

(30) Priorität: 02.06.2000 DE 10027052
(43) Veröffentlichungstag der Anmeldung: 19.03.2003
(73) Patentinhaber: MicroGaN GmbH, 89081 Ulm (DE)
(72) Erfinder: KOHN, Erhard, 89081 Ulm-Lehr (DE); DAUMILLER, Ingo, 88316 Isny (DE); KAMP, Markus, 47475 Kamp-Lintfort (DE); SEYBOTH, Matthias, 89179 Beimerstetten (DE)
(74) Vertreter: Pfenning, Meinig & Partner GbR
(86) Internationale Anmeldenummer: PCT/EP2001/006279
(87) Internationale Veröffentlichungsnummer: WO 2001/092428

(56) Entgegenhaltungen:
- WO-A-00/21143
- US-A- 5 571 732
- ASBECK P M ET AL: "Enhancement of base conductivity via the piezoelectric effect in AlGaN/GaN HBTs" SOLID STATE ELECTRONICS, ELSEVIER SCIENCE PUBLISHERS, BARKING, GB, Bd. 44, Nr. 2, Februar 2000 (2000-02), Seiten 211-219, XP004186190 ISSN: 0038-1101
- MORKOC H ET AL: "Polarization effects in nitride semiconductor device structures and performance of modulation doped field effect transistors" SOLID STATE ELECTRONICS, ELSEVIER SCIENCE PUBLISHERS, BARKING, GB, Bd. 43, Nr. 10, Oktober 1999 (1999-10), Seiten 1909-1927, XP004182890 ISSN: 0038-1101

## Beschreibung

Die vorliegende Erfindung bezieht sich auf eine Heterostruktur wie sie beispielsweise für Feldeffektransistoren in der Leistungselektronik und Hochtemperaturelektronik eingesetzt werden. Dabei werden insbesondere Heterostrukturen, die einen In(Ga)N-Kanal, eine (Al)GaN-Cap-Schicht und eine GaN-Pufferschicht aufweisen, verwendet. Aufgrund der Materialeigenschaften von GaN und dessen Verbindungen wie AlGaN und InGaN werden diese Heterostrukturen in den letzten Jahren intensiv beforscht, um Anwendungen in der Leistungselektronik und Hochtemperaturelektronik zu ermöglichen.

Bei Heterostrukturen, die einen In(Ga)N-Kanal, eine (Al)GaN-Cap-Schicht und eine GaN-Pufferschicht oder -Substrat aufweisen, ist der InGaN-Kanal aufgrund der unterschiedlichen Gitterkonstanten von GaN und InGaN verspannt. Materialbedingt entstehen dadurch im GaN/InGaN/GaN-System piezoelektrische Felder, die an den Grenzflächen polarisierte Ladungen (Piezoladungen) erzeugen. Eine GaN/InGaN/GaN-Heterostruktur besitzt dabei eine positive Grenzflächenladung am InGaN/GaN und eine negative Grenzflächenladung am GaN/InGaN-Übergang (Interface). Die erzeugten Grenzflächenladungen können bei einem Indiumgehalt von 100 % eine Ladungsträgerdichte von 1,3 x 10¹⁴ cm⁻² erreichen. Der Vorteil dieser Struktur besteht darin, daß die durch die piezoelektrischen Felder erzeugten Ladungen sich im Kanal befinden. Aufgrund der Materialeigenschaften von GaN bilden sich zusätzlich spontane Polarisationsladungen an der Oberfläche und der Pufferrückseite, die jedoch nur einen sekundären Einfluß auf die Transistoreigenschaften haben.

Piezoelektrische Felder in GaN/InGaN-Heterostrukturen spielen auch eine wesentliche Rolle, wenn diese Strukturen als strahlungsemitterende Halbleiterchips (Leuchtdiode) eingesetzt werden. In WO 00/21143 weist die aktive Schicht in einer solchen Heterostruktur eine Einfach- oder Mehrfach-Quantenwell-Struktur auf. Um den das Strahlungsverhalten solcher Halbleiterchips beinträchtigenden Einfluß den piezoelektrischen Feldern in den Quantenfilmen zu eliminieren, werden diese Felder durch Dotierung möglichst vollständig beseitigt.

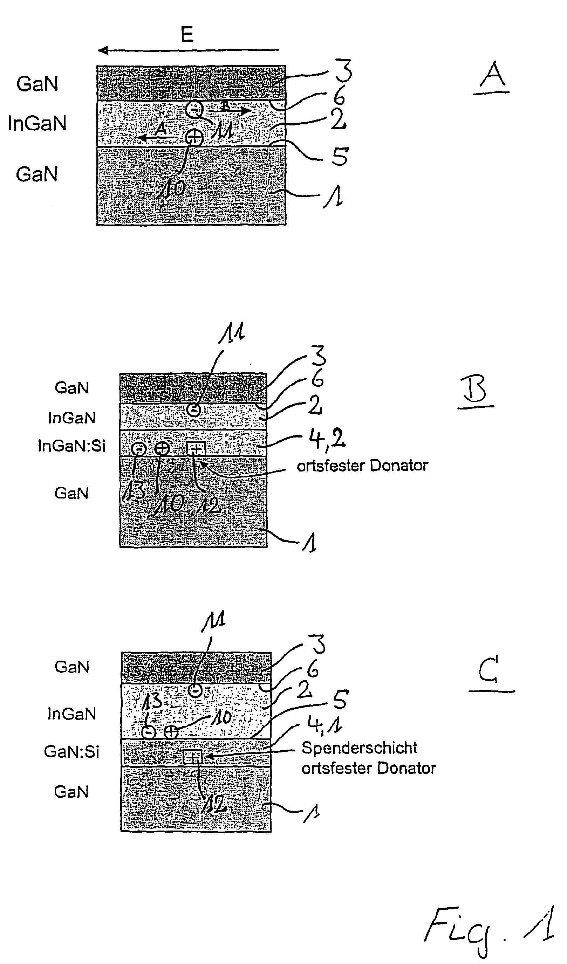

Fig. 1 zeigt in ihrem Teilbild 1A eine solche Heterostruktur mit einem Puffer 1, einem Kanal 2, einer Cap-Schicht 3 und den Grenzflächen 5 bzw. 6 zwischen den Schichten 1/2 bzw. den Schichten 2/3. Weiterhin sind die Piezoladungen dargestellt, wobei zu erkennen ist, daß die erzeugte positive Piezoladung sich an der Grenzfläche 5 befindet und die erzeugte negative Piezoladung sich an der Grenzfläche 6 befindet. Unter dem Einfluß eines angelegten äußeren elektrischen Feldes E bewegen sich nun die Piezoladungen entgegengesetzt gemäß den Pfeilen A und B.

In der Literatur sind modulationsdotierte (MODFET), kanaldotierte und undotierte (Piezo-FET) AlGaN/GaN-Feldeffektransistoren bekannt. Auch im AlGaN/GaN-System führen Verspannungen zu piezoelektrischen Feldern, die an den Grenzflächen polarisierten Ladungen bilden. Im Gegensatz zu einem GaN/InGaN/GaN-System befinden sich nicht beide Grenzflächenladungen im Kanal, sondern die negative Ladung am AlGaN/GaN-In terface als 2DEG (2-diversivales Elektronengas) und die positive Ladung an der AlGaN-Oberfläche.

Der Nachteil einer solchen Struktur ist, daß die gebundene Grenzflächenladung an der AlGaN/GaN-Grenzfläche mit der gegenpoligen Oberflächenladung durch die polarisierenden Felder in Wechselwirkung zueinanderstehen. Die Oberflächenladungen nehmen im DC-Betrieb eines GaN-basierenden Transistors wenig Einfluß auf die Ausgangscharakteristik. Im RF-Betrieb muß die Ladung an der Oberfläche der Kanalladung aufgrund ihrer Wechselwirkung folgen. Vorausgesetzt die Ladungen im Kanal bewegen sich mit höherer Geschwindigkeit als die Oberflächenladung, so folgt bei einer charakteristischen Frequenz im RF-Betrieb die Oberflächenladung nicht mehr der Kanalladung. Diese jetzt gegenpolige quasi ortsfeste Ladung verletzt die Neutralitätsbedingung und kann nun die freien Ladungen im Kanal einfangen, mit der Konsequenz, daß der Ausgangsstrom abnimmt und die maximale RF-Leistung sich gegenüber der DC-Leistung reduziert.

Im Gegensatz zum AlGaN/GaN-System befindet sich im GaN/InGaN/GaN-System keine durch die piezoelektrische Polarisation erzeugte Grenzflächenladung an der Probenoberfläche. Eine Wechselwirkung zwischen piezoelektrischer Polarisationsladung und Oberflächenladung wird vermieden. Dadurch wird der Effekt der Stromkompensation und dem resultierenden Leistungsabfall bei höherfrequenter Eingangsleistung, der bei AlGaN/GaN-Transistoren zu beobachten ist, verhindert.

In einer GaN/InGaN/GaN tragen zum Stromtransport die positive Grenzflächenladung am rückseitigen InGaN/GaN-Interface und die induzierte negative Grenzflächenladung am GaN/InGaN vorderseitigen Interface bei. Im Vergleich zu GaN oder AlGaN ist die Elektronenbeweglichkeit in InGaN wesentlich höher und kann nach theoretischen Berechnungen 4500cm²/Vsec betragen. Die Beweglichkeit von Löchern ist im InGaN allerdings um ein Vielfaches geringer als die Elektronenbeweglichkeit. Der resultierende Nettostromfluß gegeben durch die positive Grenzflächenladung und negative Grenzflächenladung, ist bestimmt durch die Bedingung der Ladungsneutralität, d. h. der langsamere Löcherstrom bestimmt die resultierende Grenzfrequenz des Bauelements. Zudem kann der Kanal durch einen pn-Übergang gesperrt werden.

Aufgabe der vorliegenden Erfindung ist es nun, die oben beschriebenen Nachteile bei Heterostrukturen mit einem Kanal aus einem piezopolaren Material zu vermeiden.

Diese Aufgabe wird durch die Heterostruktur gemäß Patentanspruch 1 und dem Feldeffektransistor gemäß Patentanspruch 24 sowie die Verwendung gemäß Patentanspruch 28 gelöst. Vorteilhafte Weiterbildungen der Heterostruktur bzw. des Feldeffektransistors werden in den jeweiligen abhängigen Ansprüchen gegeben.

Erfindungsgemäß werden beispielsweise durch eine dünne n-Dotierung im Kanal oder im Puffer bzw. Substrat die positive Polarisationsladung an der Grenzfläche zwischen Puffer und Kanal kompensiert, so daß nur ein Elektronenkanal resultiert. Dies ist mit Bezug auf die Figuren 1B sowie 1C dargestellt. 1B zeigt, wie durch die Dotierung mit einem ortsfesten Donator 12 bewegliche Elektronen 13 in den Kanal eingebracht werden, die mit der Piezoladung 10 rekombinieren, so daß lediglich noch die Elektronen 11 als bewegliche Ladungsträger im Kanal verbleiben.

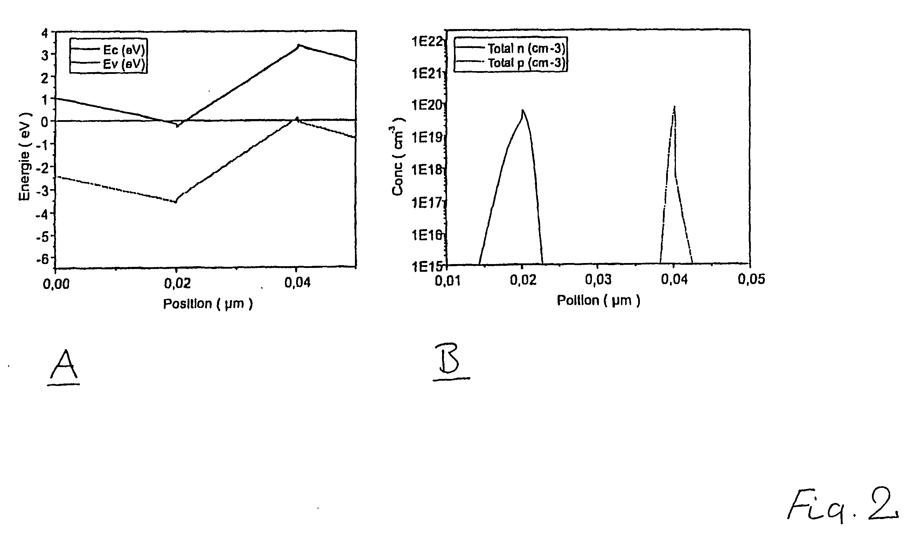

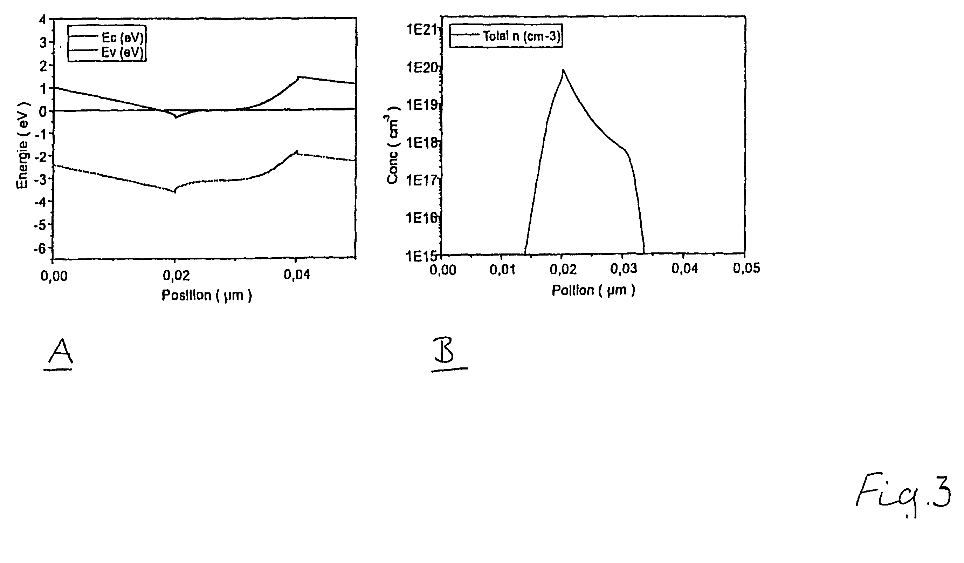

Die Fig. 1B zeigt die Verteilung der Ladung an einer invertierten GaN/InGaN/GaN HEMT-Struktur mit Donatordotierung im InGaN. Die Fig. 1C zeigt eine weitere Möglichkeit, nämlich die Verteilung der Ladung an einer invertierten GaN/InGaN/GaN HEMT-Struktur mit Donatordotierung im Puffer GaN. Deutlich zu sehen ist hier in gleicher Weise wie in Fig. 1B die Kompensation der positiven Piezoladung 10 im Kanal durch die Elektronenmodulationsdotierung aus der Spenderschicht 4, die ein dotierter Bereich des Puffers 1 ist. Als positive Gegenladung zur Elektronenkanalladung bleibt nach Rekombination der Ladung 10 und 13 lediglich eine positive ortsfeste Donatorladung 12 in der dotierten Spenderschicht 4 des Puffers 1 übrig. Fig. 2A und Fig. 2B zeigen den simulierten Wandverlauf in einem 20 nm GaN/20 nm InGaN/GaN-Puffersystem und die Ladungsträgerverteilung. Für diese Simulation sind alle Schichten undotiert und der Indiumgehalt beträgt 20 %. Demgegenüber zeigt Fig. 3A und 3B den simulierten Wandverlauf und die Ladungsträgerverteilung in einem GaN/InGaN/GaN-System mit einer N-Kompensationsladung im InGaN-Kanal wie in Fig. 1B. Für diese Simulation wurde eine 10 nm dicke N-Kompensationsdotierung (1,5 x 10¹⁹ cm⁻³) im InGaN-Kanal angenommen.

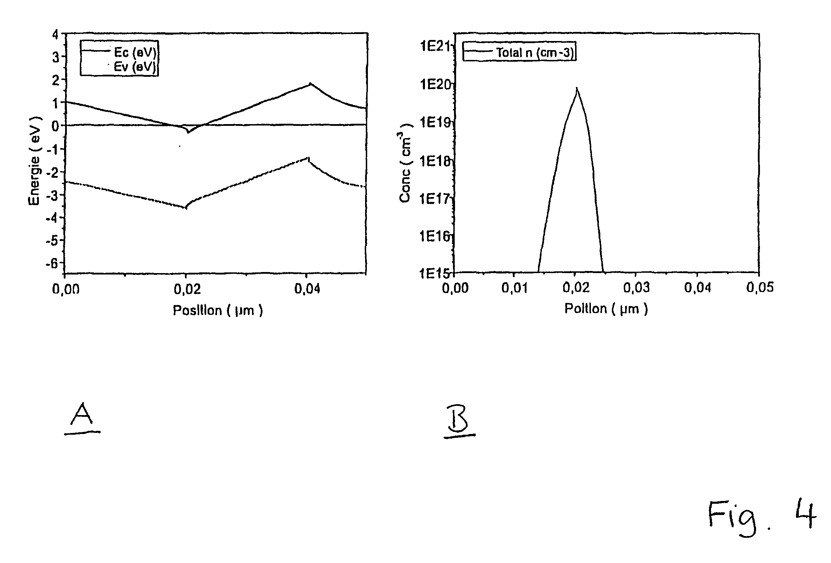

Fig. 4A und Fig. 4B zeigen eine entsprechende Simulation eines Systems wie in Fig. 1C, d.h. mit einer 10 nm dicken N-Kompensationsdotierung (1 x 10¹⁹ cm⁻³) als Spenderschicht im GaN-Puffer unterhalb des Kanals. In beiden Fällen der Fig. 3 und 4 wurde die Dotierung exakt so gewählt, daß der Löcherkanal kompensiert wurde.

Aus Fig. 3B und Fig. 4B ist im Vergleich zu Fig. 2B unmittelbar zu erkennen, daß die positiven Piezoladungen an der Grenzfläche zwischen Puffer und Kanal vollständig kompensiert wurden und folglich keine Löcherleitung im Kanal mehr vorliegt.

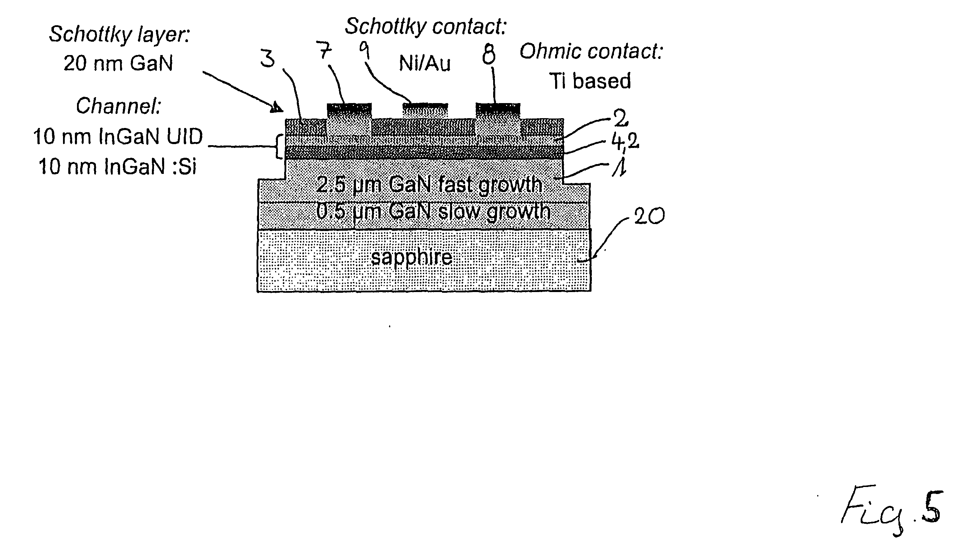

Fig. 5 zeigt den Schichtaufbau eines invertierten GaN/InGaN/GaN-Feldeffektransistors mit rückseitiger Donatordotierung gemäß der vorliegenden Erfindung. Hier erfolgte die Dotierung mit Silizium als ortsfestem Donator (2 x 10¹⁸ cm⁻³) in einer 10 nm dicken InGaN-Schicht, die an der Grenzfläche zwischen dem Kanal 2 und dem Puffer 1 liegt. Der Feldeffektransistor wurde auf ein Substrat aus Saphir aufgebracht und zusätzlich mit Kontaktelektroden 7, 8 und einer Torelektrode 9 (Gate-Elektrode) versehen.

Der Indiumgehalt beträgt in der 10 nm undotierten InGaN-Schicht des Kanals 2 und in der 10 nm dicken dotierten InGaN:Si-Schicht 4, 2 ca. 7 %. Der 3 µm dicke Puffer 1 und die 20 nm dicke Cap-Schicht 3 sind jeweils undotiert.

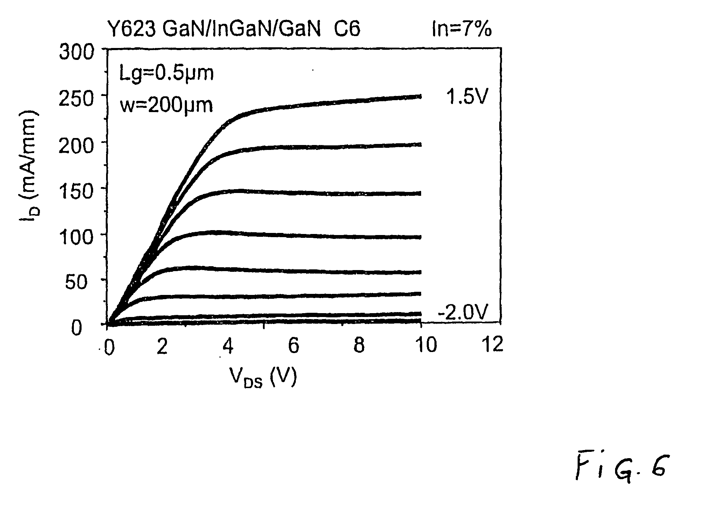

Fig. 6 zeigt die Ausgangskennlinie dieser FET-Struktur mit 20 nm GaN undotiert als Cap-Schicht, 10 nm InGaN undotiert als Kanal, 10 nm InGaN dotiert (2 x 10¹⁸ cm⁻³) als Kompensationsschicht mit einem Indiumgehalt von 7 % und einer 3 µm dicken GaN-Pufferschicht, die ebenfalls undotiert ist. Die Gate-Länge. Die Gate-Länge wurde zu 0,5 µm gewählt. Hierbei wurde nun ein maximaler Sättigungsstrom von 250 mA/mm erreicht.

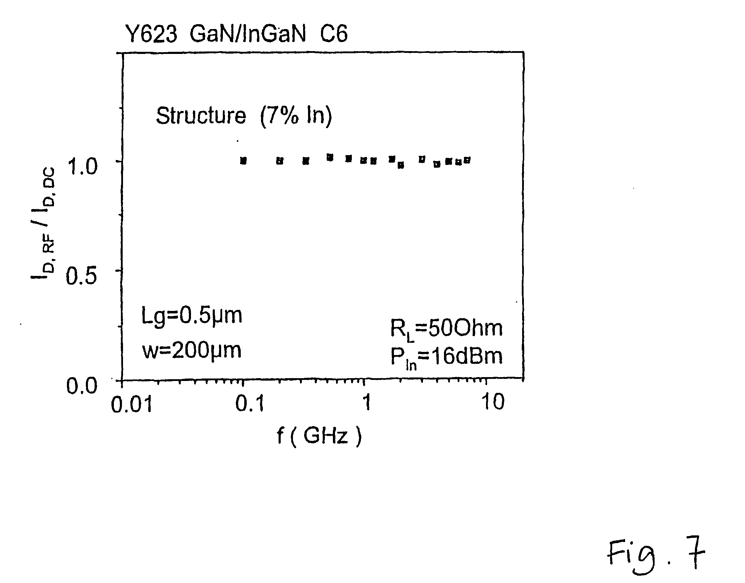

Im abgeschnürten Zustand wurde mit einem derartigen FET eine Durchbruchspannung von 120 V erreicht. Das ergab eine Ausgangsleistung von 2,5 W/mm. Im RF-Betrieb konnte mit einer Eingangsleistung von 16 dBm an einer 50 Ohm Lastgerade bis 10 kHz keine Stromkompression festgestellt werden. Dies ist in Fig. 7 dargestellt, die den maximalen RF-Ausgangsstrom normiert auf den maximalen DC-Ausgangsstrom in Abhängigkeit von der Frequenz bei diesem FET aus Fig. 5 zeigt.

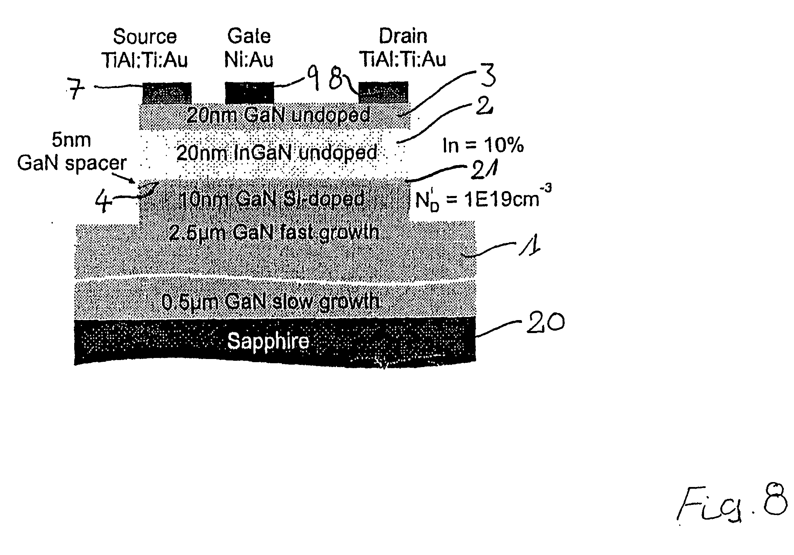

Fig. 8 zeigt den Schichtaufbau eines invertierten InGaN-basierenden HEMT mit rückseitiger Donatordotierung, der ebenfalls realisiert wurde.

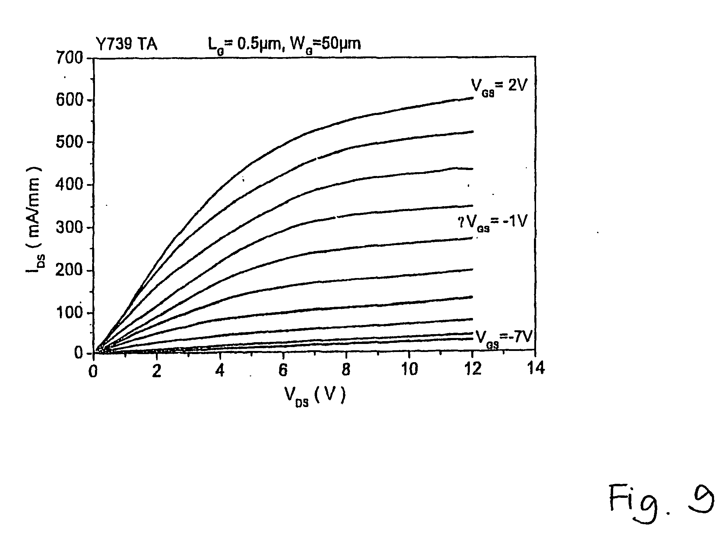

Die Donatordotierung von 1 x 10¹⁹ cm⁻³ befindet sich in einer 10 nm dicken GaN-Schicht 4 unterhalb des InGaN-Kanals 2, von diesem getrennt durch eine 5 nm dicke undotierte GaN-Spacerschicht 21 zur Trennung der Dotierrümpfe. Der Indiumgehalt beträgt in der 20 nm undotierten InGaN-Schicht 2 10 %. Der 3 µm dikke GaN-Puffer 1 und die 20 nm dicke GaN-Cap-Schicht 3 sind undotiert. In den Fig. 9 und 10 sind die Ausgangskennlinien dieser Struktur dargestellt. Bei einem Transistor mit 0,5 µm Gate-Länge (Fig. 9) bzw. mit 0,25 µm Gate-Länge (Fig. 10) wurde ein maximaler Sättigungsstrom von 600 mA/mm bzw. 900 mA/mm erreicht.

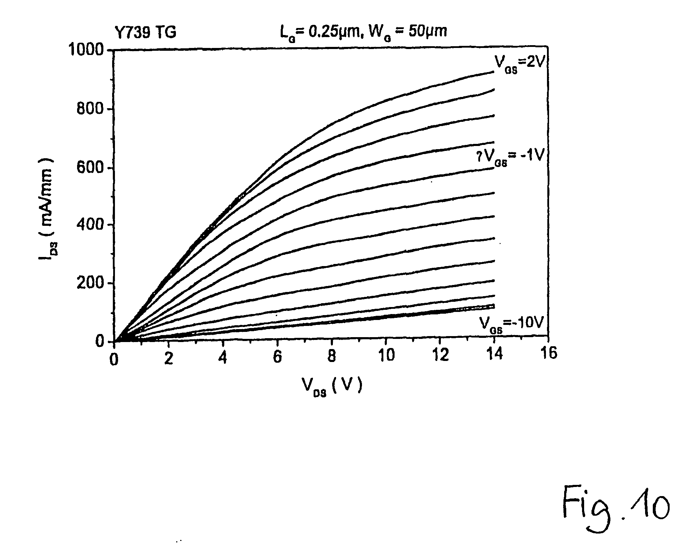

Mit den bisherigen Beispielen, die im wesentlichen Fig. 1B bzw. 1C entsprachen, wurde dargestellt, daß durch eine Donatorkompensationsdotierung der freien Löcher in einem InGaN-basierenden invertierten HEMT-Struktur ein freier Elektronenkanal entsteht. Es ist jedoch prinzipiell auch möglich, eine Akzeptor-Kompensationsdotierung der freien Elektronen durchzuführen und so einen freien Löcherkanal zu erzeugen. Dies ermöglicht es, komplementäre Logikschaltungen aufzubauen (in Analogie zur CMOS-Schaltung). In Fig. 11 ist der Aufbau eines derartigen Inverters mit einem N-Kanal und einem P-Kanal aus InGaN-basierten HFET dargestellt. Dabei wurden für die selben Schichten dieselben Bezugszeichen verwendet, wobei in dem P-Kanal-System die entsprechenden Bezugszeichen als gestrichene Bezugszeichen dargestellt werden (z.B. 3' statt 3 für die Cap-Schicht). Der Schichtaufbau des N-Kanal-Transistors ist dabei entsprechend Fig. 8. Der P-Kanal-Transistor besteht aus einem 3 µm dicken undotierten GaN-Puffer 1, den der P-Kanal-Transistor mit dem N-Kanal-Transistor in gemein hat, einer 20 nm dicken undotierten InGaN-Schicht 2' mit 10 % Indiumgehalt als Kanal, einer 5 nm dicken magnesiumdotierten GaN-Schicht zur Kompensationsdotierung des hierzu induzierten Elektronenkanals mit einer Akzeptorkonzentration von 2 x 10¹⁹ cm⁻³ sowie einer 20 nm dicken undotierten GaN-Cap-Schicht 3'. Sowohl im N-Typ als auch im P-Typ-Transistor befindet sich zwischen dem Kanal und der dotierten Schicht eine Space-Schicht 21 bzw. 21'.

Zur Angleichung der beiden Potentiale des N-Typ-Transistors bzw. des P-Typ-Transistors unter dem Gate-Bereich der beiden Transistoren wird ein Isolator 22, beispielsweise aus SiO₂ oder SiN, zwischen den Gates 9, 9' und dem Halbleitermaterial der Cap-Schicht 3, 3' plaziert.

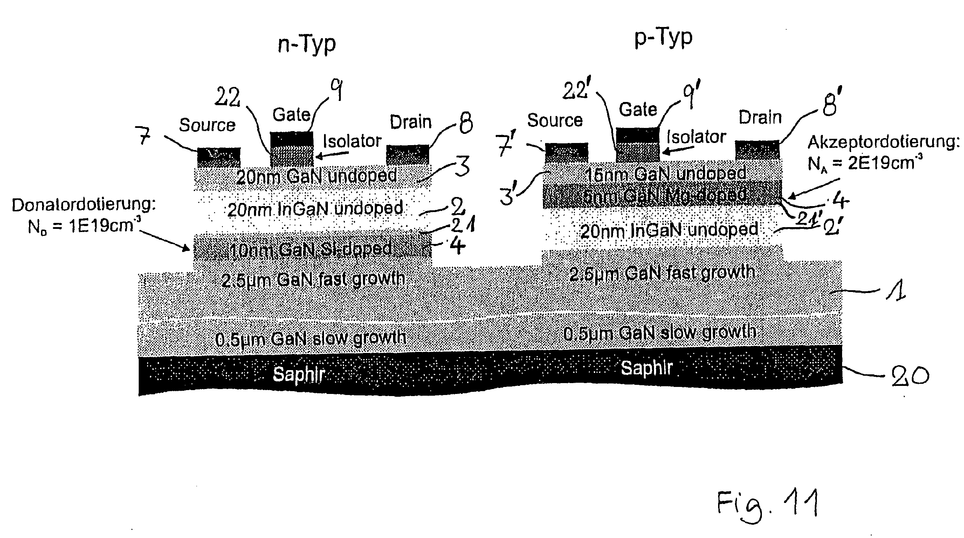

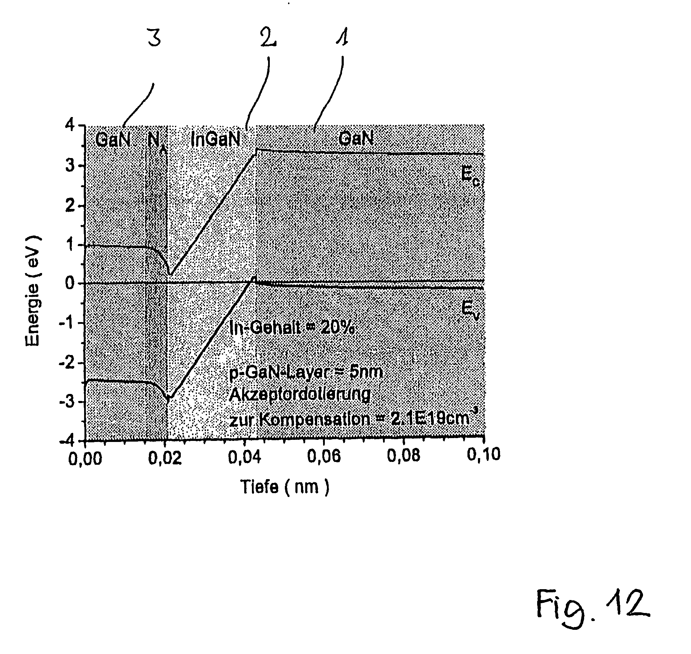

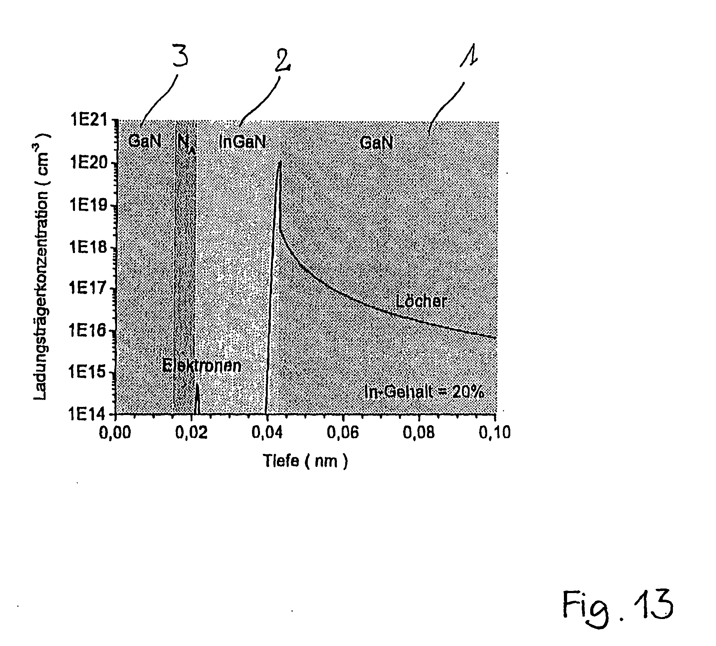

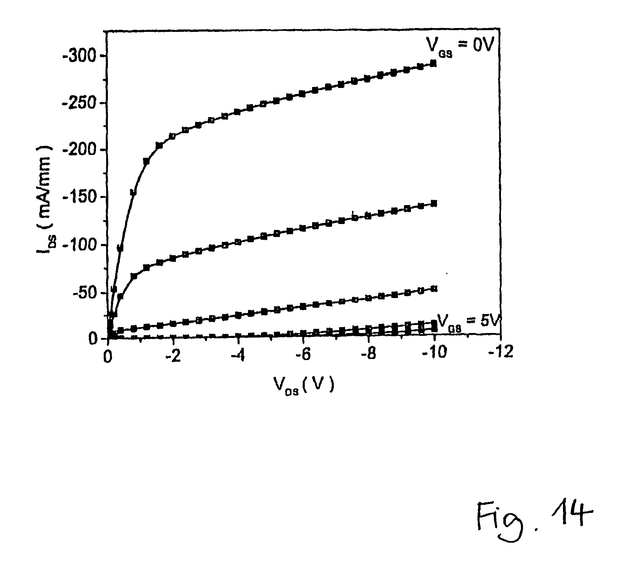

Fig. 12 und Fig. 13 zeigen den Bandverlauf bzw. die Ladungsträgerverteilung einer wie im rechten Teilbild der Figur 11 aufgebaut dargestellten P-Kanal InGaN-basierenden Heterostruktur mit N-Kompensationsdotierung. Bei Anlegen einer negativen Grain-Source-Spannung und einer positiven Gate-Spannung wird damit ein P-Kanal-Transistor realisiert. Dies wird in Fig. 14 dargestellt, in der die DT-Ausgangskennlinie eines derartigen P-Kanal-HFET mit 0,5 µm Gate-Länge dargestellt ist.

## Patentansprüche

1. Heterostruktur mit einer Pufferschicht bzw. Substrat, einem auf der Pufferschicht bzw. dem Substrat angeordneten Kanal sowie einer auf dem Kanal angeordneten Cap-Schicht, wobei der Kanal aus einem piezopolaren Material besteht so daß sowohl an der Grenzfläche zwischen Pufferschicht bzw. Substrat und Kanal sowie an der Grenzfläche zwischen Kanal und Cap-Schicht Piezoladungen jeweils unterschiedlichen Ladungstyps entstehen,
**dadurch gekennzeichnet, daß**
entweder der Bereich um die Grenzfläche zwischen Pufferschicht bzw. Substrat und Kanal oder der Bereich um die Grenzfläche zwischen Kanal und Cap-Schicht derart dotiert ist, daß die an der jeweiligen Grenzfläche auftretenden Piezoladungen kompensiert werden.

2. Heterostruktur nach dem vorhergehenden Anspruch, **gekennzeichnet durch** eine GaN-Pufferschicht bzw. Substrat, einen auf der Pufferschicht bzw. dem
- Substrat angeordneten InGaN-Kanal sowie eine auf dem Kanal angeordnete GaN- oder AlGaN-Cap-Schicht, wobei entweder der Bereich um die Grenzfläche zwischen Pufferschicht bzw. Substrat und Kanal n-dotiert ist oder
der Bereich um die Grenzfläche zwischen Kanal und Cap-Schicht p-dotiert ist.

3. Heterostruktur nach einem der vorhergehenden Ansprüche, **dadurch gekennzeichnet, daß** der Bereich um die Grenzfläche zwischen Pufferschicht bzw. Substrat und Kanal derart n-dotiert ist, daß die in dem Kanal vorhandenen piezoinduzierten positiven Ladungen kompensiert werden.

4. Heterostruktur nach Anspruch 1 oder 2, **dadurch gekennzeichnet, daß** der Bereich um die Grenzfläche zwischen Kanal und Cap-Schicht derart p-dotiert ist, daß die in dem Kanal vorhandenen piezoinduzierten negativen Ladungen kompensiert werden.

5. Heterostruktur nach einem der vorhergehenden Ansprüche, **dadurch gekennzeichnet, daß** der dotierte Bereich als Zwischenschicht zwischen Pufferschicht bzw. Substrat und Kanal bzw. zwischen Kanal und Cap-Schicht ausgebildet ist.

6. Heterostruktur nach dem vorhergehenden Anspruch, **dadurch gekennzeichnet, daß** die Zwischenschicht eine GaN-Schicht oder InGaN-Schicht ist.

7. Heterostruktur nach Anspruch 5, **dadurch gekennzeichnet, daß** die Zwischenschicht eine Zusammensetzung wie die entsprechende ihr benachbarte Pufferschicht bzw. Substrat, Kanal oder Cap-Schicht aufweist.

8. Heterostruktur nach einem der vorhergehenden Ansprüche, **dadurch gekennzeichnet, daß** der dotierte Bereich bzw. die Zwischenschicht von dem Kanal durch eine undotierte Abstandschicht getrennt ist.

9. Heterostruktur nach dem vorhergehenden Anspruch, **dadurch gekennzeichnet, daß** die Abstandschicht eine GaN-Schicht ist.

10. Heterostruktur nach einem der Ansprüche 2 oder 6, **dadurch gekennzeichnet, daß** der Indiumgehalt in der InGaN-Schicht zwischen 1 % und 99 % je einschließlich beträgt.

11. Heterostruktur nach dem vorhergehenden Anspruch, **dadurch gekennzeichnet, daß** der Indiumgehalt in der InGaN-Schicht zwischen 5 % und 30 % je einschließlich beträgt.

12. Heterostruktur nach dem vorhergehenden Anspruch, **dadurch gekennzeichnet, daß** der Indiumgehalt in der InGaN-Schicht zwischen 7 % und 20 % je einschließlich beträgt.

13. Heterostruktur nach dem vorhergehenden Anspruch, **dadurch gekennzeichnet, daß** der Indiumgehalt in der InGaN-Schicht 7 %, 10 % oder 20 % beträgt.

14. Heterostruktur nach einem der vorhergehenden Ansprüche, **dadurch gekennzeichnet, daß** die Dicke der Pufferschicht bzw. des Substrats zwischen 1 und 10 µm, der Zwischenschicht zwischen 5 und 50 nm, der Abstandsschicht zwischen 1 und 20 nm, des Kanals zwischen 5 und
50 nm und/oder der Cap-Schicht zwischen 5 und 50 nm beträgt.

15. Heterostruktur nach dem vorhergehenden Anspruch, **dadurch gekennzeichnet, daß** die Dicke der Pufferschicht bzw. des Substrats etwa 3 µm, der Zwischenschicht etwa 10 nm, der Abstandschicht etwa 5 nm, des Kanals etwa
10 nm oder 20 nm und/oder der Cap-Schicht etwa 20 nm beträgt.

16. Heterostruktur nach einem der vorhergehenden Ansprüche, **dadurch gekennzeichnet, daß** der Bereich um die Grenzfläche zwischen der Pufferschicht bzw. dem Substrat und dem Kanal eine Donatordotierung zwischen 1 · 10¹⁸ cm⁻³ und 2 · 10¹⁹ cm⁻³ aufweist.

17. Heterostruktur nach dem vorhergehenden Anspruch, **dadurch gekennzeichnet, daß** der Bereich um die Grenzfläche zwischen der Pufferschicht bzw. dem Substrat und dem Kanal eine Donatordotierung zwischen 2 · 10¹⁸ cm⁻³ und 1 · 10¹⁹ cm⁻³ je einschließlich aufweist.

18. Heterostruktur nach Anspruch 16, **dadurch gekennzeichnet, daß** der Bereich um die Grenzfläche zwischen der Pufferschicht bzw. dem Substrat und dem Kanal eine Donatordotierung von 1 · 10¹⁸ cm⁻³ oder 2 · 10¹⁹ cm⁻³ aufweist.

19. Heterostruktur nach einem der vorhergehenden Ansprüche, **dadurch gekennzeichnet, daß** der Dotierstoff für die Dotierung im Bereich um die Grenzfläche zwischen der Pufferschicht bzw. dem Substrat und dem Kanal Silizium ist.

20. Heterostruktur nach einem der vorhergehenden Ansprüche, **dadurch gekennzeichnet, daß** der Bereich um die Grenzfläche zwischen Kanal und Cap-Schicht eine Akzeptordotierung zwischen 1 · 10¹⁸ cm⁻³ und 5 · 10¹⁹ cm⁻³ aufweist.

21. Heterostruktur nach dem vorhergehenden Anspruch, **dadurch gekennzeichnet, daß** der Bereich um die Grenzfläche zwischen Kanal und Cap-Schicht eine Akzeptordotierung zwischen 2· 10¹⁸ cm⁻³ und 2 · 10¹⁹ cm⁻³ je einschließlich aufweist.

22. Heterostruktur nach dem vorhergehenden Anspruch, **dadurch gekennzeichnet, daß** der Bereich um die Grenzfläche zwischen Kanal und Cap-Schicht eine Akzeptordotierung von 2 · 10¹⁹ cm⁻³ aufweist.

23. Heterostruktur nach einem der vorhergehenden Ansprüche, **dadurch gekennzeichnet, daß** der Dotierstoff für die Dotierung im Bereich um die Grenzfläche zwischen Kanal und Cap-Schicht Magnesium ist.

24. Feldeffekttransistor mit einer Heterostruktur nach einem der vorhergehenden Ansprüchen, **dadurch gekennzeichnet, daß** auf der dem Kanal abgewandten Oberfläche der Cap-Struktur zwei Kontaktelektroden und eine Torelektrode (Gateelektrode) angeordnet sind.

25. Feldeffekttransistor nach dem vorhergehenden Anspruch, **dadurch gekennzeichnet, daß** die beiden Kontaktelektroden sperrfreie S- bzw. D-Kontakte sind.

26. Feldeffekttransistor nach einem der Ansprüche 24 oder 25, **dadurch gekennzeichnet, daß** die Gateelektrode eine Schottky-Metall-Gateelektrode ist.

27. Feldeffekttransistor nach einem der Ansprüche 24 bis 26, **dadurch gekennzeichnet, daß** die Gateelektrode einen p⁻-dotierten Gatekontakt aufweist.

28. Verwendung von Heterostrukturen und Feldeffekttransistoren nach einem der vorhergehenden Ansprüche für die Leistungselektronik oder Hochtemperaturelektronik, in Feldeffektransistoren oder Logikschaltungen, insbesondere komplementären Logikschaltungen.

## Claims

1. Heterostructure with a buffer layer, i.e. substrate, a channel located on the buffer layer, i.e. the substrate, as well as a cap layer located on the channel, whereby the channel consists of a piezopolar material, so that piezo charges of different charge types are created on the border surface between the buffer layer, i.e. the substrate and the channel as well as on the border surface between the channel and the cap layer, **characterised in that** either the area around the border surface between the buffer layer, i.e. the substrate and the channel or the area around the border surface between the channel and the cap layer are doped in such a way that the piezo charges occurring on the relevant border surface are compensated.

2. Heterostructure according to the preceding Claim, **characterised by** a GaN buffer layer, i.e. substrate, an InGaN channel located on the buffer layer, i.e. the structure, as well as a GaN or AlGaN layer located on the channel, whereby either the area around the border surface between the buffer layer, i.e. the substrate and the channel is n-doped, or the area around the border surface between the channel and the cap layer is p-doped.

3. Heterostructure according to one of the preceding Claims, **characterised in that** the area around the border surface between the buffer layer, i.e. the substrate and the channel is n-doped in such a way that the piezo-induced positive charges occurring within the channel are compensated.

4. Heterostructure according to Claim 1 or 2, **characterised in that** the area around the border surface between the channel and the cap layer is p-doped in such a way that the piezo-induced negative charges occurring within the channel are compensated.

5. Heterostructure according to one of the preceding Claims, **characterised in that** the doped area takes the form of an interim layer between the buffer layer, i.e. the substrate and the channel, i.e. between the channel and the cap layer.

6. Heterostructure according to one of the preceding Claims, **characterised in that** the interim layer consists of a GaN layer or an InGaN layer.

7. Heterostructure according to Claim 5, **characterised in that** the interim layer comprises a compound such as the relevant adjacent buffer layer, i.e. substrate, channel or cap layer.

8. Heterostructure according to one of the proceeding Claims, **characterised in that** the doped area, i.e. the interim layer is separated from the channel by an undoped distancing layer.

9. Heterostructure according to one of the preceding Claims, **characterised in that** the distancing layer consists of a GaN layer.

10. Heterostructure according to one of the Claims 2 or 6, **characterised in that** the indium content in the InGaN layer is between 1% and 99% inclusive.

11. Heterostructure according to the preceding Claim, **characterised in that** the indium content in the InGaN layer is between 5% and 30% inclusive.

12. Heterostructure according to the preceding Claim, **characterised in that** the indium content in the InGaN layer is between 7% and 20% inclusive.

13. Heterostructure according to one of the preceding Claims, **characterised in that** the indium content in the InGaN layer is 7%, 10% or 20%.

14. Heterostructure according to one of the preceding Claims, **characterised in that** the thickness of the buffer layer, i.e. the substrate is between 1 and 10 µm, that of the interim layer between 5 and 50 nm, that of the distancing layer between 1 and 20 nm, that of the channel between 5 and 50 nm and/or that of the cap layer between 5 and 50 nm.

15. Heterostructure according to the preceding Claim, **characterised in that** the thickness of the buffer layer, i.e. the substrate is approximately 3 µm, that of the interim layer approximately 10 nm, that of the distancing layer approximately 5 µm, that of the channel approximately 10 nm or 20 nm, and/or that of the cap layer approximately 20 nm.

16. Heterostructure according to one of the preceding Claims, **characterised in that** the area around the border surface between the buffer layer, i.e. the substrate and the channel has a donor doping of between 1 · 10¹⁸ cm⁻³ and 2 · 10¹⁹ cm⁻³.

17. Heterostructure according to the preceding Claim, **characterised in that** the area around the border surface between the buffer layer, i.e. the substrate and the channel has a donor doping of between 2 · 10¹⁸ cm⁻³ and 1 · 10¹⁸ cm⁻³ inclusive.

18. Heterostructure according to Claim 16, **characterised in that** the area around the border surface between the buffer layer, i.e. the substrate and the channel has a donor doping of 1 · 10¹⁸ cm⁻³ or 2 · 10¹⁹ cm⁻³.

19. Heterostructure according to one of the preceding Claims, **characterised in that** the doping material for doping the area around the border surface between the buffer layer, i.e. the substrate and the channel is silicon.

20. Heterostructure according to one of the preceding Claims, **characterised in that** the area around the border surface between the channel and the cap layer has an acceptor doping of between 1 · 10¹⁸ cm⁻³ and 5 · 10¹⁹ cm⁻³.

21. Heterostructure according to the preceding Claim, **characterised in that** the area around the border surface between the channel and the cap layer has an acceptor doping of between 2 · 10¹⁸ cm⁻³ and 2 · 10¹⁹ cm⁻³ inclusive.

22. Heterostructure according to the preceding Claim, **characterised in that** the area around the border surface between the channel and the cap layer has an acceptor doping of 2 · 10¹⁹ cm⁻³.

23. Heterostructure according to one of the preceding Claims, **characterised in that** the doping material for doping the area around the border surface between the channel and the cap layer is magnesium.

24. Field effect transistor with a heterostructure according to one of the preceding Claims, **characterised in that** two contact electrodes and a gate electrode are located on the surface of the cap structure facing away from the channel.

25. Field effect transistor according to the preceding Claim, **characterised in that** the two contact electrodes are barrier-free S-, i.e. D-contacts.

26. Field effect transistor according to one of the Claims 24 or 25, **characterised in that** the gate electrode is a Schottky metal gate electrode.

27. Field effect transistor according to one of the Claims 24 to 26, **characterised in that** the gate electrode comprises a p^{~}-doping gate contact.

28. Use of heterostructures and field effect transistors according to one of the preceding Claims for high performance electronics or high temperature electronics in field effect transistors or logic switches, in particular complementary logic switches.

## Revendications

1. Hétérostructure ayant une couche tampon ou un substrat, un canal ménagé sur la couche tampon ou le substrat ainsi qu'une couche d'obturation ménagée sur le canal, ce dernier étant constitué d'un matériau piézopolaire de manière à former, autant à l'interface entre la couche tampon ou le substrat et le canal qu'à l'interface entre le canal et la couche d'obturation, des charges piézoélectriques de types respectivement différents,
**caractérisée en ce que** soit la zone autour de l'interface entre la couche tampon ou le substrat et le canal, soit la zone autour de l'interface entre le canal et la couche d'obturation est dopée de manière à compenser les charges piézoélectriques apparaissant à l'interface correspondante.

2. Hétérostructure selon la revendication précédente, **caractérisée par** une couche tampon ou un substrat de GaN, un canal d'InGaN ménagé sur la couche tampon ou le substrat, ainsi que par une couche d'obturation de GaN ou d'AlGaN ménagée sur le canal, dans laquelle :
soit la zone autour de l'interface entre la couche tampon ou le substrat et le canal est dopée en type n,
soit la zone autour de l'interface entre le canal et la couche d'obturation est dopée en type p.

3. Hétérostructure selon l'une quelconque des revendications précédentes, **caractérisée en ce que** la zone autour de l'interface entre la couche tampon ou le substrat et le canal est dopée en type n de manière à compenser les charges positives piézo-induites présentes dans le canal.

4. Hétérostructure selon la revendication 1 ou 2, **caractérisée en ce que** la zone autour de l'interface entre le canal et la couche d'obturation est dopée en type p de manière à compenser les charges négatives piézo-induites présentes dans le canal.

5. Hétérostructure selon l'une quelconque des revendications précédentes, **caractérisée en ce que** la zone dopée se présente sous la forme d'une couche intermédiaire entre la couche tampon ou le substrat et le canal ou entre le canal et la couche d'obturation.

6. Hétérostructure selon la revendication précédente, **caractérisée en ce que** la couche intermédiaire est une couche de GaN ou d'InGaN.

7. Hétérostructure selon la revendication 5, **caractérisée en ce que** la couche intermédiaire présente une composition comme la couche tampon ou le substrat, le canal ou la couche d'obturation correspondant qui lui est adjacente.

8. Hétérostructure selon l'une quelconque des revendications précédentes, **caractérisée en ce que** la région dopée ou la couche intermédiaire est séparée du canal par une couche d'espacement non dopée.

9. Hétérostructure selon la revendication précédente, **caractérisée en ce que** la couche d'espacement est une couche de GaN.

10. Hétérostructure selon l'une quelconque des revendications 2 ou 6, **caractérisée en ce que** la teneur en indium dans la couche d'InGaN se situe entre 1% et 99% respectivement inclus.

11. Hétérostructure selon la revendication précédente, **caractérisée en ce que** la teneur en indium dans la couche d'InGaN se situe entre 5% et 30% respectivement inclus.

12. Hétérostructure selon la revendication précédente, **caractérisée en ce que** la teneur en indium dans la couche d'InGaN se situe entre 7% et 20% respectivement inclus.

13. Hétérostructure selon la revendication précédente, **caractérisée en ce que** la teneur en indium dans la couche d'InGaN est de 7%, 10% ou 20%.

14. Hétérostructure selon l'une quelconque des revendications précédentes, **caractérisée en ce que** l'épaisseur de la couche tampon ou du substrat se situe entre 1 et 10 µm, celle de la couche intermédiaire entre 5 et 50 nm, celle de la couche d'espacement entre 1 et 20 nm, celle du canal entre 5 et 50 nm, et/ou celle de la couche d'obturation entre 5 et 50 nm.

15. Hétérostructure selon la revendication précédente, **caractérisée en ce que** l'épaisseur de la couche tampon ou du substrat est d'environ 3 µm, celle de la couche intermédiaire d'environ 10 nm, celle de la couche d'espacement d'environ 5 nm, celle du canal d'environ 10 nm ou 20 nm, et/ou celle de la couche d'obturation d'environ 20 nm.

16. Hétérostructure selon l'une quelconque des revendications précédentes, **caractérisée en ce que** la zone comprise autour de l'interface entre la couche tampon ou le substrat et le canal présente un dopage de donneurs entre 1 • 10¹⁸ cm⁻³ et 2 • 10¹⁹ cm⁻³.

17. Hétérostructure selon la revendication précédente, **caractérisée en ce que** la zone autour de l'interface entre la couche tampon ou le substrat et le canal présente un dopage de donneurs entre 2 • 10¹⁸ cm⁻³ et 1 • 10¹⁹ cm⁻³ respectivement inclus.

18. Hétérostructure selon la revendication 16, **caractérisée en ce que** la zone autour de l'interface entre la couche tampon ou le substrat et le canal présente un dopage de donneurs de 1 • 10¹⁸ cm⁻³ ou de 2 • 10¹⁹ cm⁻³.

19. Hétérostructure selon l'une quelconque des revendications précédentes, **caractérisée en ce que** la substance de dopage pour le dopage dans la zone autour de l'interface entre la couche tampon ou le substrat et le canal est le silicium.

20. Hétérostructure selon l'une quelconque des revendications précédentes, **caractérisée en ce que** la zone autour de l'interface entre le canal et la couche d'obturation présente un dopage d'accepteurs entre 1 • 10¹⁸ cm⁻³ et 5 • 10¹⁹ cm⁻³.

21. Hétérostructure selon la revendication précédente, **caractérisée en ce que** la zone autour de l'interface entre le canal et la couche d'obturation présente un dopage d'accepteurs entre 2 • 10¹⁸ cm⁻³ et 2 • 10¹⁹ cm⁻³ respectivement inclus.

22. Hétérostructure selon la revendication précédente, **caractérisée en ce que** la zone autour de l'interface entre le canal et la couche d'obturation présente un dopage d'accepteurs de 2 • 10¹⁹ cm⁻³.

23. Hétérostructure selon l'une quelconque des revendications précédentes, **caractérisée en ce que** la substance de dopage pour le dopage dans la région autour de l'interface entre le canal et la couche d'obturation est le magnésium.

24. Transistor à effet de champ ayant une hétérostructure selon l'une quelconque des revendications précédentes, **caractérisé en ce que** deux électrodes de contact et une électrode à porte (électrode de grille) sont agencées sur la surface de la structure d'obturation opposée au canal.

25. Transistor à effet de champ selon la revendication précédente, **caractérisé en ce que** les deux électrodes de contact sont des contacts S ou D non bloquants.

26. Transistor à effet de champ selon l'une quelconque des revendications 24 ou 25, **caractérisé en ce que** l'électrode de grille est une électrode de grille en métal à barrière Schottky.

27. Transistor à effet de champ selon l'une quelconque des revendications 24 à 26, **caractérisé en ce que** l'électrode de grille présente un contact de grille dopé en type p.

28. Utilisation d'hétérostructures et de transistors à effet de champ selon l'une quelconque des revendications précédentes, pour l'électronique de puissance ou l'électronique haute température, dans des transistors à effet de champ ou des circuits logiques, en particulier des circuits logiques complémentaires.
